Europäisches Patentamt

European Patent Office

Office européen des brevets

(11) Publication number: **0 311 435**
**A2**

## (12) EUROPEAN PATENT APPLICATION

(21) Application number: **88309393.2**

(22) Date of filing: **07.10.88**

(51) Int. Cl.⁴: **H 01 L 23/50**

(30) Priority: **09.10.87 GB 8723734**

(43) Date of publication of application:
**12.04.89 Bulletin 89/15**

(84) Designated Contracting States: **CH DE FR GB LI**

(71) Applicant: **THE DE LA RUE COMPANY PLC**
**De La Rue House 3/5 Burlington Gardens**
**GB-London W1A 1DL  (GB)**

(72) Inventor: **Etherington, Harry James Charles**
**"Tallarna", Grosvenor House**
**Godalming Surrey GU7 1PA  (GB)**

**Newman, Roger Keith**
**Meadow Croft Hoe Road**
**Bishops Waltham Southampton Hampshire  (GB)**

(74) Representative: **Skone James, Robert Edmund et al**
**GILL JENNINGS & EVERY 53-64 Chancery Lane**
**London WC2A 1HN  (GB)**

(54) **IC carrier assembly.**

(57) An IC carrier assembly comprises a substrate (12) having an aperture (22) and an associated conductor pattern (63). The conductor pattern (63) defines a number of conductors overlying the aperture (22). An IC element (11) is bonded to all the overlying conductors (65) via respective contacts (66) to form the assembly. The contacts of the IC element which are bonded to the conductors and the conductors themselves are substantially symmetrically arranged about a line of symmetry (25).

Fig.3.

**Description**

## IC CARRIER ASSEMBLY

The invention relates to an IC carrier assembly and a method for its manufacture.

The development of integrated circuit (IC) chips requires that these chips or elements are mounted to carrier substrates on which are provided conductor patterns to enable electrical contact to be achieved between contacts on the chip and remote apparatus. The combination of a carrier substrate and an IC element is known as an IC carrier assembly. Recently, it has been proposed to incorporate such IC carrier assemblies in integrated circuit cards, for example for use as credit and charge cards. This has lead to particular difficulties in fabricating a strong construction utilising IC carrier assemblies due to the unique stress problems associated with such cards encountered during construction of the card, typically a lamination process, and during subsequent use. One result of the stresses encountered is that the connections between the IC element and the carrier element can be broken. In addition, in certain circumstances the IC element itself can break.

One method by which this problem could be overcome is to bond the element rigidly to a substrate but this leads to a relatively inflexible card.

In accordance with one aspect of the present invention, a method of manufacturing an IC carrier assembly comprises providing a substrate having an aperture and an associated conductor pattern, the conductor pattern defining a number of conductors overlying the associated aperture, and bonding in a single bonding step all the overlying conductors to respective contacts of an IC element in the associated aperture to form an IC carrier assembly, the contacts of the IC element which are bonded to the conductors being substantially symmetrically arranged about a line of symmetry.

In accordance with a second aspect of the present invention, an IC carrier assembly comprises a substrate having an aperture and an associated conductor pattern, the conductor pattern defining a number of conductors overlying the associated aperture; and an IC element having a number of contacts bonded to respective overlying conductors, the contacts of the IC element which are bonded to the conductors being substantially symmetrically arranged about a line of symmetry.

We have discovered that the problems of stresses in the contact/conductor bonds can be significantly reduced by connecting the IC element in a substantially symmetrical manner to the conductor pattern. This ensures that the IC element is flexibly but securely mounted so that during subsequent handling the loads are substantially equally distributed between the bonds.

In one example this symmetry is achieved by bonding the overlying conductors to substantially equal numbers of contacts on each side of the line of symmetry.

Typical IC elements used in integrated circuit cards have both functional and non-functional contacts. In this case, preferably at least one of the conductors is bonded to a non-functional contact and most preferably as many contacts as possible are bonded to overlying conductors. This gives additional mechanical strength during processes following bonding when the IC carrier assembly is incorporated into a larger device such as an integrated circuit card, and during subsequent use of such cards.

A further problem which has been encountered is that one or more of the substrate, the conductor pattern and adhesive used to bond the two has an inherent distortion. This can cause significant weakening of the contact/conductor bonds.

In accordance with a third aspect of the pressent invention, a method of manufacturing an IC carrier assembly comprises providing a substrate having an aperture and an associated conductor pattern, the conductor pattern defining a number of conductors at least some of which overlie the associated aperture, and bonding all the overlying conductors to respective contacts of an IC element in the associated aperture to form an IC carrier assembly, the conductors of the conductor pattern being substantially symmetrically arranged about a line of symmetry.

In accordance with a fourth aspect of the present invention, an IC carrier assembly comprises a substrate having an aperture and an associated conductor pattern, the conductor pattern defining a number of conductors at least some of which overlie the associated aperture; and an IC element having a number of contacts bonded to respective overlying conductors, the conductors of the conductor pattern being substantially symmetrically arranged about a line of symmetry.

Conveniently, the conductor pattern includes an outer ground conductor extending around the periphery of the conductor pattern and arranged substantially symmetrically about the line of symmetry.

We have found that in the case of an elongate substrate, for example in the form of a tape from which a number of carrier assemblies are formed, the symmetrical arrangement of the conductor pattern ensures that the substrate is substantially flat when presented for bonding.

In this case, the conductor patterns are preferably spaced apart along the tape to reduce the distortion effect.

Typically, the substrate will comprise an elongate tape, each line of symmetry extending transversely, preferably orthogonally, to the length of the substrate.

The conductor pattern may be provided in any conventional manner but preferably a layer of conductive material, such as copper, is bonded to a support, such as polyimide, the conductive layer subsequently being etched to define the conductor patterns.

An example of a method for fabricating an integrated circuit card incorporating an IC carrier assembly constructed in accordance with the present invention will now be described with reference to the accompanying drawings, in which:-

       Figure 1 is an exploded view of the card;

       Figure 2 is a perspective view of an IC module incorporated the assembly;

       Figure 3 is a plan of the conductor pattern provided by the IC carrier assembly;

       Figure 4 is an enlarged cross-section through part of the card;

       Figure 5 is a schematic plan of part of a tape carrying a number of IC modules; and,

       Figure 6 is a schematic cross-section through part of an IC module.

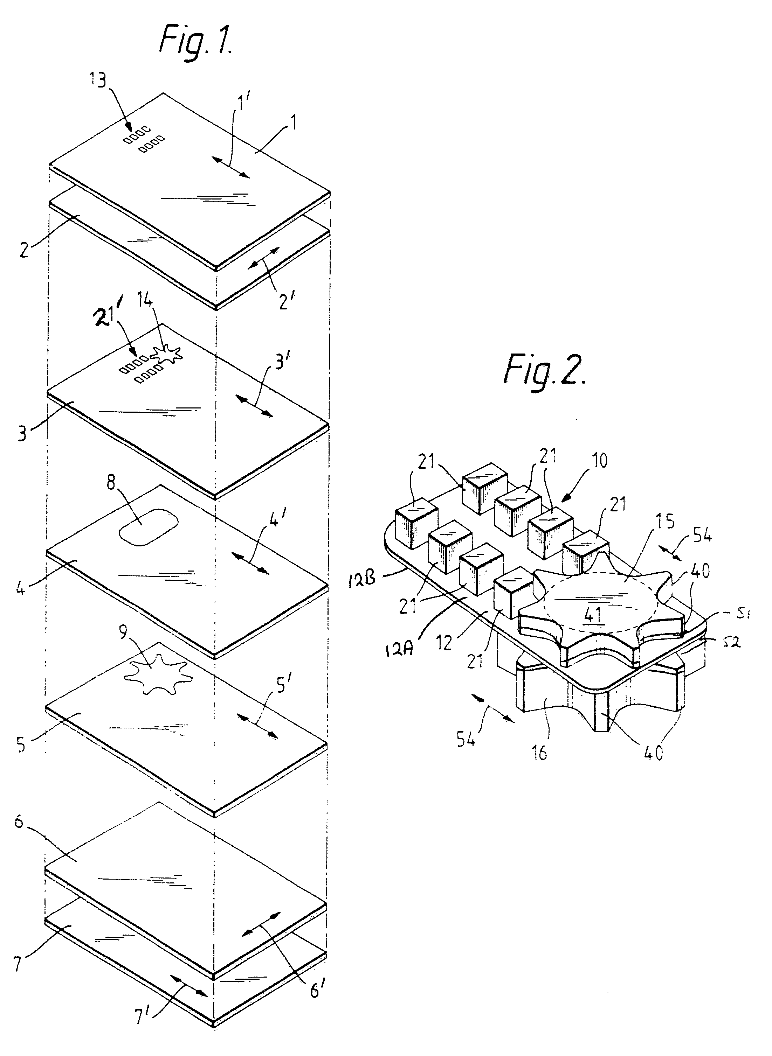

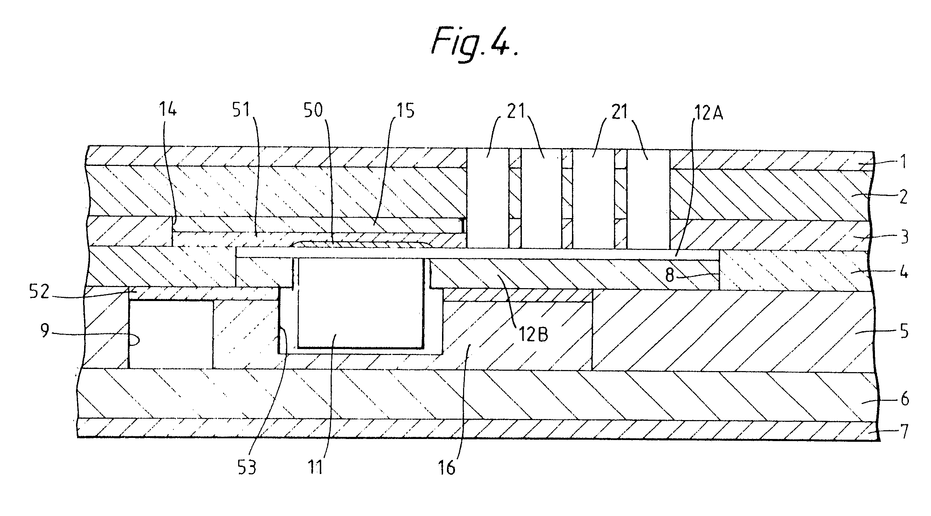

The integrated circuit card comprises a laminate, as shown in Figures 1 and 4, having a number of plastics layers 1-7. The plastics layers 1-7 typically comprise PVC, PVCA or similar materials. The thickness of these layers is set out in Table 1 below.

### TABLE 1

| Layer Number | Pre-lamination Thickness($\mu$m) |
| --- | --- |
| (1) | 60 |
| (2) | 150 |
| (3) | 120 |
| (4) | 120 |
| (5) | 250 |
| (6) | 150 |
| (7) | 60 |

After lamination, the total thickness of the card will reduce to about 780$\mu$m.

Each layer has a grain due to the method of manufacture in which the sheets are rolled and calendered causing some alignment of the molecular structure. Consequently, each layer is "stiffer" across the grain than along the grain. The grain direction of each layer is indicated in Figure 1 by arrows 1' - 7' respectively and it will be seen that the grain direction of layers 2 and 6 is transverse to that of the remaining layers. These layers 2,6 are typically opaque and carry printing on their outwardly facing surfaces. Due to their thickness relative to the other layers and their positions towards the outside of the card there is a significant risk of cracking of these two layers when the card is bent in its short dimension, if the grain of these layers were in the long dimension. The reason for changing the grain direction in these layers is that this leads to a card in which there is a much lower risk of cracking of the printed layers. Also, a generally similar degree of resistance to flexure in all directions is achieved. These improvements lead to a longer lifetime. If all the laminae were to be laid with the grain in the same direction, then the result would be a "stiff" card in the axis across the grain. This is undesirable since, from a bending/torsion viewpoint, it is preferred that the card is equally flexible in all directions relative to the "stress reduction" members of the IC Module (to be described).

In the case of plastics layers 1-7 formed by rolling and/or calendering, the "grain" is considered to extend in the long direction of the forming process, ie. the direction of movement of the plastics through the forming apparatus. Typically, this is the predominant direction of shrinkage when the plastics is subjected to heat.

Embedded within the card is an IC module 10 (Figure 2) consisting of a chip 11 defining a single chip microprocessor such as the Hitachi 65901 mounted to a chip carrier 12 formed by a layer of copper 12A on a polyimide layer 12B such as Kapton to define a carrier assembly. The chip carrier 12 is received in an aperture 8 of the layer 4. As will be explained in more detail below, a pair of star shaped stress reduction members 15, 16 are embedded in apertures 14, 9 respectively of the layers 3, 5 in alignment with the chip 11.

As will be explained in more detail below, contacts on the chip 11 are coupled via conductors of the copper layer 12A on the chip carrier 12 with contact members 21 which protrude through the layers 1-3 to allow physical contact with a card reader.

In the finished card, the layers 1, 7 are transparent to allow the printing on layers 2, 6 to be read by the user.

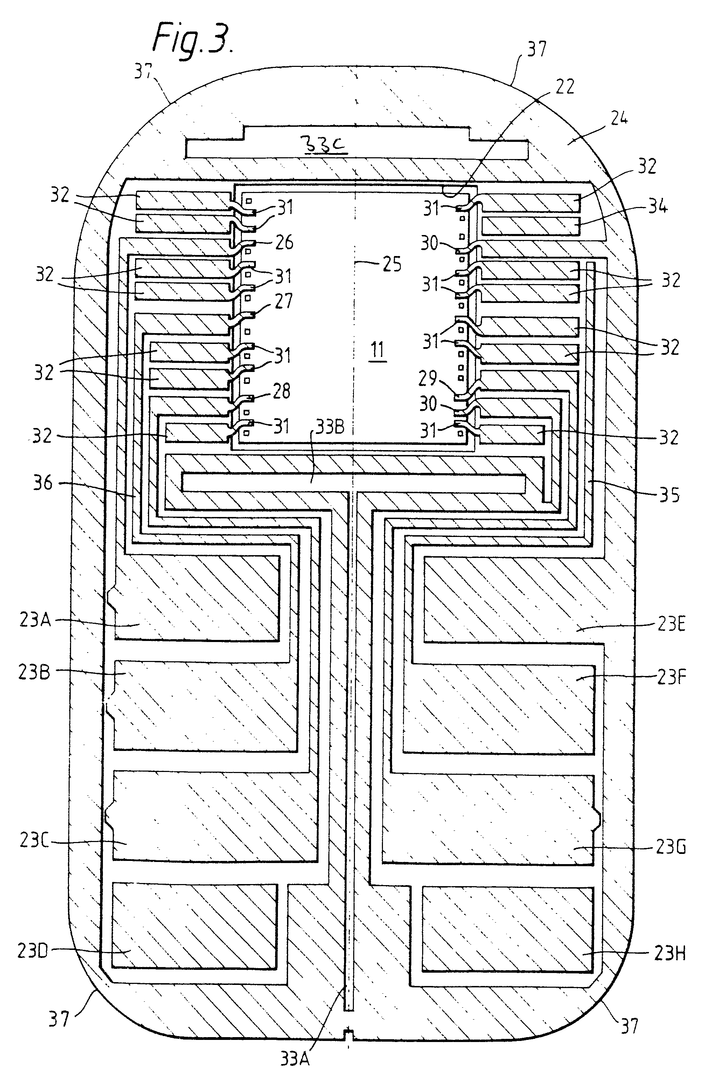

The module shown in Figure 2 is constructed as a separate unit which is then laminated with the layers 1-7. The chip carrier 12 is cut from a Kapton (polyimide) substrate 12B (thickness 75$\mu$m) on which is provided the layer 12A of copper foil (thickness 35$\mu$m) adhered by an epoxy to the Kapton layer 12B. The copper is etched to provide a conductor pattern shown in more detail in Figure 3. In addition the Kapton is punched to provide an aperture 22 in which the chip 11 is received.

It will be seen in Figure 3 that the conductor pattern defines eight contact pads 23A-23H to which the contact members 21 are individually bonded. In addition, the conductor pattern has an outer ground plane 24 extending around the pattern. It should be noted that the contact pads 23A-23H are substantially symmetrically arranged about a line of symmetry 25.

The contact pad 23A is connected with a functional contact 26 of the chip 11; the contact pad 23B is connected to a functional contact 27 of the chip; the contact pad 23C is connected to a functional contact 28 of the chip, and the contact pad 23G is connected to a functional contact 29 of the chip 11. Two functional contacts 30 are connected to the ground plane 24 as is the contact pad 23E. Contact pads 23D, 23F and 23H are isolated.

In addition, a number of non-functional contacts 31 of the chip 11 are connected to respective, short conductors 32 of the conductor pattern such that the arrangement of the conductor pattern adjacent to the chip 11 is substantially symmetrical about the line of symmetry 25. In addition, an isolated conductor 34 is provided to complete the symmetrical arrangement.

In this case, it will be seen that the conductor pattern is bonded to ten contacts of the chip 11 on the left hand side of Figure 3 and nine contacts on the right hand side. This small difference in the number of bonded contact positions is acceptable and the term "substantially symmetrical" should be interpreted accordingly. This substantially symmetrical arrangement of contacts connected to conductors allows the chip 11 to be securely supported in the aperture 22 of the carrier 12 and reduces the risk of undue twisting of the chip 11 within the aperture 22, whilst allowing some freedom of movement of the chip relative to the chip carrier 12. This freedom of movement is necessary to prevent damage to the chip and its connections during manufacture of the IC module 10, during lamination of the IC card, during subsequent use of the IC card. Undue twisting of the chip 11, in the aperture 22, relative to the chip carrier 12 could result in excessive stresses at the IC connections.

The remainder of the conductor pattern is also substantially symmetrical about the line of symmetry 25. In this connection, it should be noted for example that although the contact pad 23F is not connected to the chip 11, a conductor line 35 extends from the contact pad 23F to a position adjacent the chip 11 in a similar way to a conductor line 36 which extends from the contact pad 23B to the contact 27. This assists in overcoming the natural tendancy of the copper layer 12A to distort, which can otherwise weaken the bonds between the conductors and chip contacts before lamination, during lamination, and to some extent after lamination.

In addition, the copper pattern 12A is split at 33A, 33B, 33C to reduce its rigidity, so that the chip carrier 12 will more readily flex when card flexure occurs. The copper pattern is split at 33A along the line of symmetry 25, copper is etched away from a section 33B orthogonal to and communicating with the section 33A, copper is also etched away from a section 33C.

The corners 37 of the carrier 12 are rounded to help to reduce stress concentrations in the card layers at the corners of the carrier.

In constructing the module, the first step is to form the conductor pattern described above. The next step is to bond the contact members 21 to the contact pads 23A-23H.

Following this step, the IC chip 11 is located in the aperture 22 and the chip contacts are bonded to the inner ends of the conductors which overlie the aperture 22, as shown in Figure 3 and as previously described. The method chosen is Tape Automated Bonding (TAB). TAB is preferred to wire bonding since (relative to wire bonding) it provides higher bond strength, greater reliability, improved mechanical construction, and a thinner package.

TAB requires that the IC chip 11 should have its contacts "bumped" to a specified height and consistency to allow for the inner lead bonding of the chip to the carrier. The bumping normally comprises the deposition of gold onto the aluminium contacts of the chip.

After the bonding operation, a resin (polyurethane) coating 50 (Figure 4) is applied to the surface of the IC chip 11 and the inner lead bonds so as to provide for mechanical and optical protection for the chip contact/conductor bonds prior to lamination. This coating 50 is known as the "glob top".

The two star shaped members 15, 16 are then bonded to the chip carrier 12. These members 15,16 are metal and are consequently stiffer than the plastics layers 1-7. The members 15, 16 locally stiffen the card body around the chip 11, they provide a strengthening reinforcement to protect the contact/conductor bonds. The members 15, 16 are stress reduction members reducing the mechanical stresses to which the contact/conductor bonds are subject during card lamination and during card use. To avoid abrupt changes in the card stress conditions, introduced by the members, at the boundaries of the members with the card laminae a "star" shape is adopted as shown in Figure 2. The star profile provides a gradual increase in stiffness from the outer boundary of legs 40 of the star to a central section 41 indicated by a dotted line.

It should be noted that the "stiffness" of a circular plate varies inversely as the square of the diameter and directly as the cube of the thickness.

The members 15, 16 are mounted above and below the chip 11 and it is considered advantageous not to bond the members to the laminate in order to allow relative movement between the members and the laminate during flexing and twisting of the card.

The members 15, 16 are affixed to the chip carrier 12 via respective flexible double-sided adhesive tapes 51, 52 although other forms of flexible bonding could be used. However, it is important that the method used to bond the upper member 15 to the chip carrier 12 is electrically insulating since the upper member 15 contacts the conductor pattern.

In this example the upper member 15 is made of hard-rolled brass and has a thickness of about 50μm. The lower member 16 is made of hard-rolled brass with a thickness of about 150μm. The thicker lower member 16 enables an air pocket to be provided around the chip 11 by providing a machined recess 53 (Figure 4) to accommodate that portion of the chip 11 which protrudes below the chip carrier 12.

In other examples, other metals such as stainless steel or coppernickel alloy could be used. In addition the upper member 15 could be in a different metal such as stainless steel to the lower member 16 such as brass. Furthermore, the lower member 16 could be formed similar to the upper member 15 with a thickness of about 50μm and without a recess. In this case the resulting space would be filled with a suitable material such as a double sided adhesive tape, which will allow a cavity to be formed to accommodate that portion of the chip 11 that protrudes below the chip carrier 12 and, furthermore which will allow a flexible bonding to the lower member 16 and to the chip carrier 12.

It has been found that it is not necessary to cut an aperture in the double-sided adhesive tape 51 used to attach the upper member 15 to accommodate the glob-top 50 since the tape is sufficiently flexible to allow the glob-top to be impressed into it (during card lamination).

It should be noted that in the case of the members 15, 16 both being of the same thickness of about 50μm then the typical thickness of each double-sided tape is 85μm for the upper member and 200

μm for the lower member 16. It should be noted that in the case of the upper member 15 having a thickness of about 50μm and the lower member 16 having a thickness of about 150μm then the typical thickness of each double-sided tape is 85μm for both members15, 16.

It will be noted that each member 15, 16 has an odd number of legs 40 (in this example 7) so as to avoid an "axis of stress" being set up in the card laminae and extending through the star centre. This also allows the legs 40 of the upper member 15 to fit conveniently with the contact members 21.

In this example, the diameter of the central section 41 of the upper member 15 is made to correspond to the diagonal dimension of the chip 11, for example 9mm and the outer boundary (defined by the tips of the legs 40) is 13mm to suit the width of the chip carrier 12 and the contact arrangement. For the lower member 16, the central section is made to correspond to the width of the chip carrier 12 and has a diameter of about 15mm and the outer boundary is made to suit the card boundaries with a diameter of about 21mms.. Preferably, the two members 15, 16 are positioned so that the legs 40 do not align, in order to avoid possible stress concentrations.

In most examples, each member 15, 16 will have a constant thickness but in some cases, some tapering could be provided from the inner annulus towards the legs.

The completed module 10 (Figure 2) is then assembled with the PVC card layers 1-7 within which it is to be laminated. The module is located in a punched aperture 8 in the layer 4 which is shaped to conform to the chip carrier 12. The layer 5 has a punched star-shaped aperture 9 conforming to the lower member 16 while the layer 3 has a punched aperture 14 having a star-shape conforming to the upper stress reduction member 15 and a set of eight punched apertures 21' through which the contact members 21 protrude. In addition, the layers 1, 2 have sets of eight punched apertures, one set of which is shown at 13 through which the contact members 21 extend so as to finish substantially flush with the outer surface of the layer 1.

It will be noted that the orientation of the chip carrier 12 is transverse to the long axis of the layers 1-7. This orientation is best, from the point of view of card bending/torsion.

The assembled pre-laminate including the module is then laminated using conventional lamination machinery (heated presses). The normal (plastic identification card) lamination technique is to place the lamina build-up into a pre-heated press and immediately apply full pressure (compressing the lamina sheets together). In an alternative method, the applied pressure is gradually increased. For example, the press may be pre-heated to 140°C and then pressure applied in steps. Finally, the laminate is cooled for about 10 minutes with the pressure maintained at its highest value.

It is important that during the lamination process the chip 11 and the contact/conductor bonds are not subjected to undue compressive stresses due to bending. The silicon material has a compressive breaking stress of 15000 lb per square inch but the tensile breaking stress is only 3000 lb per square inch.

The members 15, 16 provide the major resistance to undesirable tensile stresses within the chip 11 and the contact/conductor bonds but in addition use is made of the "pocketing" of the chip in an air filled cavity as defined by the machined recess 53 in the lower member 16. This is because the surrounding gas (air) is readily compressible and will therefore transport the compression forces during laminating uniformly to the chip without subjecting the chip 11 to undesirable tensile stresses due to bending.

The preferred stress reduction members 15, 16 are made from metals, such as hard-rolled stainless steel and brass which exhibit a grain. This causes the members to take up a natural curvature, due to the hard rolling method, which is "memorised" even when the member is flattened. To optimise performance, therefore, it is preferred if this grain extends across the card, that is parallel with the short dimension of the card, while the natural bow or curvature of both members 15, 16 is outwardly of the card. The grain direction of the members 15, 16 is indicated in Figure 2 by arrows 54.

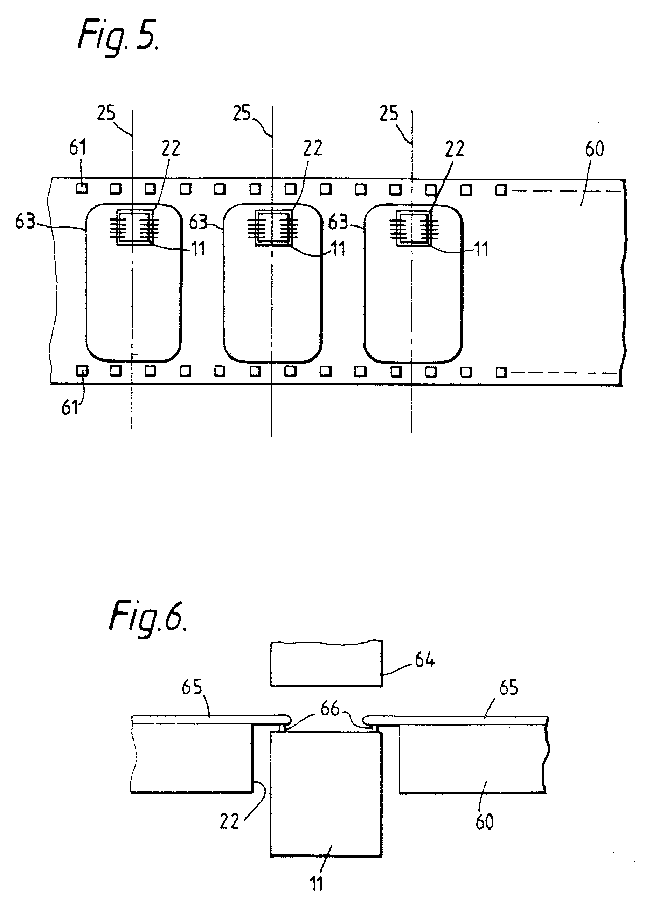

The process of manufacturing a number of IC modules 10 is illustrated by Figures 5 and 6. Initially, a substrate 60 comprising a 35 mm wide strip of Kapton having a thickness of about 75μm and provided with sprocket apertures 61 extending along each side is punched with a number of the apertures 22 at spaced positions along its length. The apertures 22 are large enough to receive the respective IC chips or elements 11 and each is symmetrically arranged about a respective line 25.

Next, a layer of copper (with a thickness of about 35μm) is adhesively bonded to the Kapton strip 60 and etched into respective conductor patterns 63, each conductor pattern being associated with a respective aperture 22 and being substantially symmetrical about the associated line 25. The conductor pattern 63 is illustrated in detail in Figure 3 and has been described in detail earlier.

After the conductor patterns 63 have been formed, the conductors 65 overlying each aperture 22 are bonded to contacts 66 of a respective IC element 11 using a thermocompression head 64 in a tape automated bonding method.

In a separate bonding operation before or after the bonding operation just described, the strip 60 is fed to an auxiliary bonding machine where the contact members 21 are bonded to the contacts 23A-23H respectively.

Subsequent to the bonding steps, the glob top of resin 50 is spread over the top surface of the chip 11 so as to coat the bonded conductors. The stress reduction members 15, 16 are then bonded on.

Finally, the finished strip is punched into individual modules 10.

Each module 10 is then handled separately and is laminated into a respective integrated circuit card as previously described.

**Claims**

1. A method of manufacturing an IC carrier assembly, the method comprising providing a substrate (60) having an aperture (22) and an associated conductor pattern (63), the conductor pattern (63) defining a number of conductors overlying the associated aperture, and bonding in a single bonding step all the overlying conductors (65) to respective contacts (66) of an IC element (11) in the associated aperture to form an IC carrier assembly, the contacts of the IC element which are bonded to the conductors being substantially symmetrically arranged about a line of symmetry (25).

2. A method according to claim 2, wherein the overlying conductors (65) are bonded to substantially equal numbers of contacts on each side of the line of symmetry (25).

3. A method according to claim 1 or claim 2, wherein the IC element (11) has at least one non-functional contact which is bonded to an overlying conductor (65).

4. A method of manufacturing an IC carrier assembly, the method comprising providing a substrate (60) having an aperture (22) and an associated conductor pattern (63), the conductor pattern (63) defining a number of conductors at least some of which overlie the associated aperture, and bonding all the overlying conductors (65) to respective contacts (66) of an IC element (11) in the associated aperture to form an IC carrier assembly, the conductors of the conductor pattern being substantially symmetrically arranged about a line of symmetry (25).

5. A method according to claim 4 and any of claims 1 to 3, wherein the lines of symmetry (25) are coincident.

6. A method according to claim 4 or claim 5, wherein the conductor pattern (63) includes an outer ground conductor (24) extending around the periphery of the conductor pattern and arranged substantially symmetrically about the line of symmetry (25).

7. A method according to any of the preceding claims, wherein the conductor pattern (63) has been etched from a layer of conductive material bonded to a support layer.

8. A method of manufacturing a number of IC carrier assemblies, the method comprising repeatedly carrying out a method according to any of the preceding claims, the substrate comprising an elongate tape on which is provided a number of conductor patterns spaced apart along the tape.

9. An IC carrier assembly comprising a substrate (60) having an aperture (22) and an associated conductor pattern (63), the conductor pattern (63) defining a number of conductors overlying the associated aperture; and an IC element (11) having a number of contacts bonded to respective overlying conductors, the contacts of the IC element which are bonded to the conductors being substantially symmetrically arranged about a line of symmetry (25).

10. An assembly according to claim 9, wherein the overlying conductors (65) are bonded to substantially equal numbers of contacts on each side of the line of symmetry (25).

11. An assembly according to claim 9 or claim 10, wherein the IC element (11) has at least one non-functional contact which is bonded to an overlying conductor (65).

12. An IC carrier assembly comprising a substrate (60) having an aperture (22) and an associated conductor pattern (63), the conductor pattern (63) defining a number of conductors at least some of which overlie the associated aperture; and an IC element (11) having a number of contacts bonded to respective overlying conductors, the conductors of the conductor pattern being substantially symmetrically arranged about a line of symmetry (25).

13. An assembly according to claim 12, and any of claims 9 to 11, wherein the lines of symmetry are coincident.

14. An assembly according to claim 12 or claim 13, wherein the conductor pattern (63) includes an outer ground conductor (24) extending around the periphery of the conductor pattern and arranged substantially symmetrically about the line of symmetry (25).

# Fig.1.

# Fig.2.

Fig.3.

# Fig.4.

EP 0 311 435 A2

*Fig. 5.*

*Fig. 6.*